# EUROPEAN PATENT APPLICATION

(11) **EP 2 747 411 A1**
(43) Date of publication of application: **25.06.2014**
(21) Application number: 12825092.5
(22) Date of filing: 07.06.2012
(51) Int. Cl.: H04N 5/225, H04N 5/369

(54) **IMAGING ELEMENT MODULE AND METHOD FOR MANUFACTURING SAME**

(30) Priority: 19.08.2011 JP 2011179853
(71) Applicant: FUJIFILM Corporation, Tokyo 106-0031 (JP)
(72) Inventor: HAMADA, Shu, Saitama-shi, Saitama 331-9624 (JP); SHIMAMURA, Hitoshi, Saitama-shi, Saitama 331-9624 (JP); TAKASE, Yoshiyuki, Saitama-shi, Saitama 331-9624 (JP)
(74) Representative: HOFFMANN EITLE
(86) International application number: PCT/JP2012/064703
(87) International publication number: WO 2013/027464

(57) **Abstract**

The front face of an opening (12) in a first wiring substrate (11) is covered by a transparent substrate (15), a light-receiving face is made to face the opening (12) of the first wiring substrate (11), and an imaging element chip (13) is flip-chip bonded to the rear face side of the first wiring substrate (11). A gap (18) formed between connection terminals (14) between the periphery of the light-receiving face of the imaging element chip (13) and the peripheral edge section of the opening (12) in the first wiring substrate (11) is buried in a first resin, and the entire rear face of the imaging element chip (13) and the rear face side of the first wiring substrate (11) are covered by a second resin (30) (30a). At the front face on this rear face side, an exposed conductive portion substantially parallel with the front face of the transparent substrate (15) is covered with the second resin (30). A second wiring substrate (22) is electrically and mechanically connected to the first wiring substrate (11).

## Description

### Technical Field

The invention relates to an imaging element module that is mounted on an electronic device such as a portable phone having a camera, and a method for manufacturing the same.

### Background Art

As disclosed in Patent Documents 1 and 2, when an imaging element module is mounted on an electronic device, an imaging lens unit is provided at a front side part of a light-receiving face of the imaging element module. The imaging element module having a lens is attached to an inner face of a housing rear face side of the electronic device and a tip of the imaging lens unit is attached so that it is flush with a housing surface. That is, according to the related art, it is possible to use a housing thickness from a surface of the housing of the electronic device to a rear face side thereof for the camera.

However, for example, as a portable phone having a camera is made to be multi-functionalized and to be thinner, a space for mounting the imaging element module on the electronic device is gradually reduced and thinned. In the portable phone having a camera, as a liquid crystal display screen is developed to be larger, it is necessary to attach the camera and a liquid crystal display unit with being overlapped in the housing, so that a small space, which is obtained by subtracting a thickness of the liquid crystal display unit from the housing thickness, can be used for the camera. Although the imaging lens is also developed to be thinner, it is required to thin a thickness of the imaging element module itself.

However, when the imaging element module is simply made to be thin, a problem that foreign materials and the like are reflected in a captured image occurs. The problem is described with reference to Fig. 3. Fig. 3 is the same as Fig. 4 of Patent Document 3.

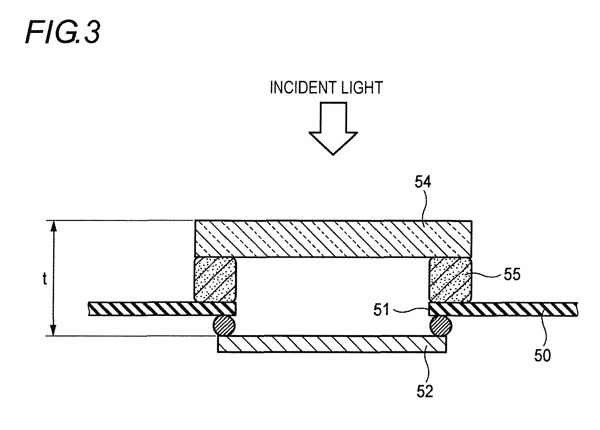

In Fig. 3, an opening is formed at a predetermined position of a flexible substrate 50 and an imaging element chip 52 is attached at a rear face side of the flexible substrate 50 with a light-receiving face thereof facing towards the opening 51. At a front side part of the opening 51 of the flexible substrate 50, a cover glass 54 is adhered by an adhesive 55. An imaging lens unit (not shown) is provided at an incident light side of the cover glass 54.

In the imaging element module having the above structure, when a distance t between a surface of the cover glass 54 and a surface of the imaging element chip 52 is short, a shadow of dust and the like attached on the surface of the cover glass 54 is reflected in an image captured by the imaging element chip 52. In order to avoid this problem, it is necessary to set the distance t to be about 300 µm, for example.

In the example shown in Fig. 3, the imaging element chip 52 is attached to the flexible substrate 50 having high flexibility with a fragile semiconductor substrate thereof being exposed, so that it is apt to be damaged. For this reason, when incorporating the imaging element module in a narrow housing of the electronic device, it is necessary to form a gap between a rear face of the imaging element chip 52 and an inner surface of the housing so as to prevent the imaging element chip 52 from being damaged due to collision with the housing. However, the housing thickness of the electronic device should be increased, as the gap.

Fig. 6 of Patent Document 1 discloses a technology of the related art covering a rear face side of an imaging element chip with a resin. Like this, when the rear face side of the fragile imaging element chip is covered with the resin, even though shock is applied to the imaging element chip, a possibility that the chip will be damaged is decreased. However, when the resin is provided, a thickness of the imaging element chip is further thickened, as the resin, so that it is difficult to accommodate the imaging element module in a narrow housing. For this reason, it is required to think about a preferable thickness of the resin, but Patent Document 1 does not consider the same.

Also, as shown in Fig. 6 of Patent Document 1, when the rear face side of the imaging element module is covered with the resin, the resin is enabled to flow through a gap, which is formed between a peripheral edge of an opening of a wiring substrate and a peripheral edge of the imaging element chip, upon filling of the resin, so that the light-receiving face may be stained. However, Patent Document 1 does not consider the problem. When the imaging element chip is made to be large, even though the resin at the periphery of the light-receiving face protrudes, the protrusion is little problematic. However, as the imaging element chip is made to be smaller, the protrusion becomes problematic.

### Prior Art Document

### Patent Document

Patent Document 1: Japanese Patent Application Publication No.: 2003-051973A
Patent Document 2: Japanese Patent Application Publication No.: 2004-335794A
Patent Document 3: Japanese Patent Application Publication No.: 2007-194272A

### Summary of Invention

### Problems to Be Solved by Invention

An object of the invention is to provide an imaging element module in which an imaging element chip can be incorporated in a space without being damaged even though the space is narrow and thin, a light-receiving face of the imaging element chip can be kept clean and a shadow of dust and the like is little reflected in an captured image, and a method for manufacturing the imaging element module.

### Means for Solving Problems

According to an imaging element module and a method for manufacturing the same of the invention, a first wiring substrate is formed with an opening, a front-side face of the opening of the first wiring substrate is covered by a transparent substrate, an imaging element chip is flip-chip bonded to a rear face side of the first wiring substrate with a light-receiving face being made to face the opening of the first wiring substrate, a gap formed between connection terminals of an electric connection part between a periphery of the light-receiving face of the imaging element chip and a peripheral edge part of the opening of the first wiring substrate is filled with a first resin, an entire rear face of the imaging element chip and the rear face side of the first wiring substrate are covered by a second resin, so that an exposed conductive part, which is exposed to the rear face side so that a surface of the rear face side is substantially parallel with a surface of the transparent substrate, is covered by the second resin and a second wiring substrate is electrically and mechanically connected to the first wiring substrate.

### Advantageous Effects of Invention

According to the invention, since the entire rear face of the imaging element chip is covered with the resin film, it is possible to reduce a concern about the damage of the chip made of a fragile material even when the imaging element chip is made to be thin and to mount the imaging element chip in an electronic device with being closely contacted.

Like this, since and the thickness of the imaging element module can be made to be thin by thinning the imaging element chip, it is possible to take a distance to a glass substrate provided at a front side face of the imaging element chip. Thereby, a distance within which a shadow of dust and the like attached on a surface of the glass substrate is not reflected in a captured image is secured.

Furthermore, since the second resin is prevented from flowing towards the imaging element light-receiving face side by the first resin (or protective member that is used instead of the first resin) before over-coating the rear face side of the first wiring substrate by the second resin, there is no concern that the light-receiving face is polluted due to the second resin.

### Brief Description of Drawings

Figs. 1A and 1B are views showing an outward appearance of a foldable portable phone, which is an example of an electronic device on which an imaging element module (a camera module) according to an illustrative embodiment of the invention is mounted;
Fig. 2 is a longitudinally sectional view of a camera module main body according to an illustrative embodiment of the invention, which is mounted on the portable phone of Figs. 1A and 1B.
Fig. 3 is a longitudinally sectional view of an imaging element module main body of the related art.

### Mode to Carry Out Invention

Hereinafter, an illustrative embodiment of the invention will be described with reference to the drawings.

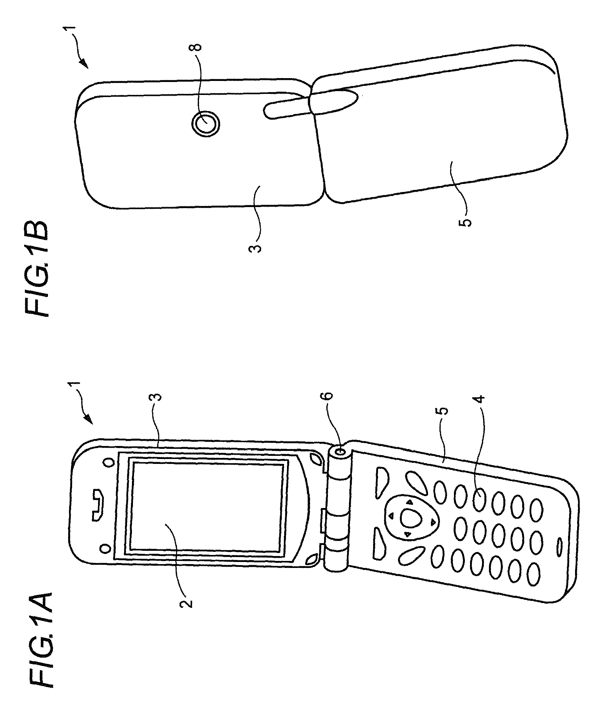

Figs. 1A and 1B show an outward appearance of a foldable portable phone, which is an example of a small-sized electronic device on which an imaging element module according to an illustrative embodiment of the invention is mounted. The foldable portable phone 1 has an upper housing 3 having a liquid crystal display unit 2 attached thereto and a lower housing 5 having press buttons 4 and the like attached thereto, which housings are connected to be freely foldable by a hinge part 6.

The liquid crystal display unit 2 of the upper housing 3 consists of a large-scaled display device, which covers most of a surface of the upper housing 3, and a camera (imaging element) module is also incorporated in the upper housing 3. Fig. 1B shows a rear face side of the portable phone 1, in which an imaging lens 8 of a camera is seen from an opening of the rear face side of the upper housing 3. That is, since the camera module is accommodated with overlapping with the liquid crystal display unit 2 in the upper housing 3, it is necessary to make a thickness of the camera module be further thinner.

The camera module has a camera module main body and an imaging lens unit that is attached to an incident light side of the main body. Although the imaging lens unit is developed to be thin, it is also necessary to make the camera module main body thin. In the below, the camera module main body is described.

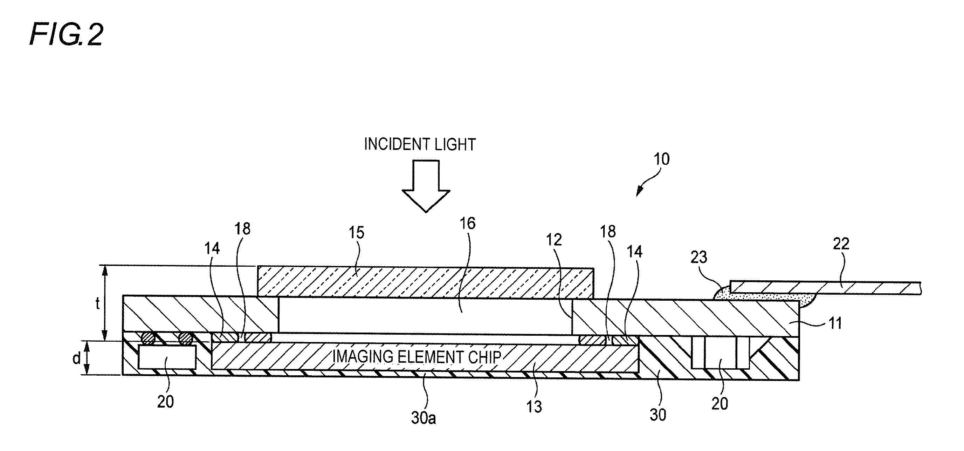

Fig. 2 is a longitudinally sectional view of a camera module main body 10. In this illustrative embodiment, a rigid wiring substrate 11 that is used for the camera module main body 10 is formed at a predetermined position with a rectangular opening 12 for incident light transmission. A bare chip (an imaging element chip) 13 of a solid state imaging device is attached at a rear face side of the rigid wiring substrate 11 by a flip-chip bonding so that a light-receiving face of the imaging element can be seen from the rectangular opening 12.

For example, gold bumps 14 are respectively put on respective terminals at a periphery of the imaging element chip 13, are matched with rear face side wiring terminals at a periphery of the rectangular opening 12 of the rigid wiring substrate 11 and are then melted by an ultrasonic bonding method, for example. Thereby, the imaging element chip 13 and the wiring terminals of the rigid wiring substrate 11 are mechanically and electrically connected. According to this method, the connection can be made at low load and low temperatures, so that it is possible to reduce a possibility that the solid state imaging device will be mechanically damaged.

Instead of using the gold bumps, a C4 (Controlled Collapse Chip Connection) connection method of using a soldering bump may be used. According to the C4 connection method, it is possible to perform the connection operation simultaneously with connection of another surface mounted-components (which will be described later), thereby reducing the cost.

Even when the imaging element chip 13 is attached at the rear face side of the rigid wiring substrate 11 by the flip-chip bonding, a gap 18 is empty between the adjacent bumps. If the gap 18 exists between the light-receiving face side of the imaging element and the periphery of the imaging element chip 13, when a rear face side of the imaging element chip 13 is covered with a resin for overcoat (hereinafter, referred to as overcoat resin) 30, which will be described later, the overcoat resin 30 protrudes towards the light-receiving face side of the imaging element through the gap 18. For this reason, it is necessary to beforehand block the gap 18 between the gold bumps 14 with a resin, thereby sealing between the solid state imaging element chip 13 and the rigid wiring substrate 11.

In order to perform the above sealing, it is preferable to block a side between the periphery of the solid state imaging element 13 and the rigid wiring substrate 11 with a resin (hereinafter, referred to as a side fill resin). Thereby, it is possible to prevent the overcoat resin 30 from protruding towards an image-capturing face and to clear the rear face side of the camera module main body 10.

Instead of the side fill resin, the gap 18 of a lower side (the rigid wiring substrate 11-side) of the periphery of the imaging element chip 13 may be blocked by a resin (hereinafter, referred to as an under fill resin). That is, the gap 18 may be blocked by enabling the under fill resin to flow into the gap 18 between the gold bumps 14 and setting the same.

As the under fill resin, it is necessary to use a resin material having low surface tension and high fluidity because it is enabled to flow into the narrow gap 18 between the gold bumps 14. Also, it is necessary to control an amount of the resin so that the under fill resin does not protrude towards the light-receiving face of the imaging element. Alternatively, a protective member may be provided in advance so that the under fill resin does not flow out towards the light-receiving face of the imaging element. For example, at a peripheral edge of the light-receiving face, the under fill resin is coated with a film having high waterproofness or is provided with a wall.

Alternatively, the solid state imaging element chip 13 and the rigid wiring substrate 11 may be electrically connected and sealed therebetween using an anisotropic conductive adhesive (ACF, ACP). The adhesive has high sealability because it is at a paste state, does not require a flux cleaning, compared to the C4 connection method and can easily remove a cause of the foreign material attachment on the imaging element chip 13.

As the rigid wiring substrate 11, a high temperature co-fired ceramic (HTCC) substrate or low temperature co-fired ceramic (LTCC) substrate may be used. The reason is because there is a low possibility that a subsequent foreign material will occur. Also, a substrate using a low-priced glass epoxy-based material may be used. In this case, it is preferable to perform dust occurrence prevention processing on an inner periphery of the rectangular opening 12 so as to suppress the occurrence of the subsequent foreign material. Preferably, the dust occurrence prevention processing may be performed using a material that prevents optical reflection, and a material in which a subsequent peeling-off and the like will not occur may be used.

A surface side of the rigid wiring substrate 11 is attached with a transparent glass substrate 15 so that all the open face of the rectangular opening 12 is covered. As the glass substrate 15, an optical filter glass (infrared cutoff filter, optical low-pass filter and the like) is used, which is adhered by an ultraviolet setting resin and the like. An internal space 16 that is formed between the light-receiving face of the imaging element chip 13 and the optical filter glass 15 is sealed by the side fill resin, the under fill resin and the optical filter glass 15, so that the dust and the like are not introduced therein.

A thickness of the rigid wiring substrate 11 is preferably within a range of 0.15 mm to 1.0 mm. The thickness, a thickness of the optical filter glass 15 and a thickness of the melted gold bump 14 define a distance t between a surface of the optical filter glass 15 and the light-receiving face of the solid state imaging element chip 13. When the distance t is set to be large, it is possible to reduce a concern that a shadow of the dust and the like attached on the surface of the optical filter glass 15 is reflected in a captured image.

To this end, in this illustrative embodiment, the 'rigid' wiring substrate 11 is used. Since the wiring substrate is rigid, a somewhat 'thickness' is secured. Also, since the imaging element chip 13 consisting of a fragile semiconductor substrate is adhered, the 'rigid' material, i.e., the material having somewhat strength is preferably used so that the wiring substrate 11 is not bent. Also, a thick flexible substrate may be used as the wiring substrate 11, on the premise that a handling for securing flatness is made.

In this illustrative embodiment, the rear face side of the rigid wiring substrate 11, i.e., the rear face side at which the imaging element chip 13 is attached is attached with another electric component (for example, a driver circuit of a lens actuator, and the like) 20 by a surface mounting method. In this case, it is preferable to make a thickness (height) of the electric component 20 be thinner than the thickness of the imaging element chip 13. Thereby, the thickness of the imaging element module 10 is not limited by the thickness of the electric component 20 and is thus made to depend on only the thickness of the imaging element chip 13. In the meantime, the surface mounting method of the electric component 20 may be a universal surface mounting method. The electric component 20 is sealed by the overcoat resin 30, like the imaging element chip 13. Since the entire rear face of the module is sealed by the overcoat resin 30, all the conductive parts such as the conductive terminals of the bare chip 13 made of semiconductor or wiring substrate, the wiring terminals of the electric component 20 and the like are not exposed to the rear face side. Thus, even when the module is mounted with being contacted to a housing in an electronic device, there is no short concern, so that the reliability can be improved.

The electric component 20 may have the thickness (height) that is thicker than the imaging element chip 13, depending on a type thereof. In this case, the electric component is preferably surface-mounted on the surface side (an incident light side: a side on which an imaging lens unit is mounted) of the rigid wiring substrate 11. Thereby, it is not necessary to thicken the imaging element module 10 for an electric component.

A flexible wiring substrate 22 is mechanically and electrically connected to an end portion of the rigid wiring substrate 11. A thickness of the flexible wiring substrate 22 is about 100 to 150 µm, for example. By using the flexible wiring substrate 22, it is possible to increase a degree of freedom of the wiring connection in the imaging element module 10 and the portable phone. The rigid wiring substrate 11 and the flexible wiring substrate 22 are mechanically and electrically connected using the anisotropic conductive adhesive (ACF, ACP) 23, for example. The anisotropic conductive adhesive 23 is suitable for connection of a narrow pitch wiring.

Alternatively, the rigid wiring substrate 11 and the flexible wiring substrate 22 may be connected using a soldering pressing method. The soldering pressing method enables the connection at low cost. As the flexible wiring substrate 22, a flexible substrate or flexible flat cable (FFC) having polyimide as a base material may be used. When the flexible flat cable is used, it is possible to reduce the cost.

In the shown illustrative embodiment, the flexible wiring substrate 22 is attached to the surface side (the side at which the imaging lens unit of the imaging optical system is attached) of the rigid wiring substrate 11. In this way, the flexible wiring substrate 22 can be connected after covering the rear face side of the rigid wiring substrate 11 with the overcoat resin 30 and attaching the imaging optical system to the imaging element module 10. Also, since it is possible to attach the flexible wiring substrate 22 later than the imaging optical system, it is possible to customize a wiring type of the flexible wiring substrate 22 in accordance with each customer to which the camera module is delivered.

The entire rear face side (the side at which the imaging element chip 13 is attached) of the rigid wiring substrate 11 is sealed by the overcoat resin 30. In this case, an overcoat resin 30a that covers the entire rear face of the imaging element chip 13 consisting of the bare chip is made to be one skin piece (a thickness thereof is about 5 to 100 µm, preferably 30 to 50 µm. Since a filler mixed in the resin has a particle diameter of about 5 to 50 µm, at least one filler is required even though the thickness thereof is thinnest. The upper limit 100 µm is a value enough to mechanically protect the imaging element chip and a thickness exceeding the upper limit is not required). This is realized by selecting a material having appropriate surface tension and viscosity as regards the overcoat resin material that can flow before it is set.

By covering the entire rear face of the imaging element chip 13 with the overcoat resin 30, it is possible to protect the imaging element chip 13 that is a fragile semiconductor chip. When mounting the imaging element module 10 in the thin housing of the electronic device, the mounting should be made so that the rear face of the imaging element module 10 is mechanically directly contacted to an inner face (a rear face side of the liquid crystal display device, in the example shown in Figs. 1A and 1B) of the housing.

Also, the imaging element chip 13 is made to be thin by cutting the rear face side thereof by about 150 to 200 µm so as to thin the imaging element module 10. As described above, the front side face of the imaging element chip 13 should have the somewhat distance t so that the shadow of the dust and the like attached on the surface of the optical filter glass 15 is not reflected in a captured image. Hence, in order to thin the imaging element module 10, it is necessary to thin not only the imaging element chip 13 itself but also the overcoat resin 30a covering the rear face of the imaging element chip 13. That is, it is necessary to thin a distance d from the light-receiving face of the imaging element chip 13 to a rear face of the overcoat resin 30a. By covering the entire rear face of the imaging element chip 13 with the overcoat resin 30a, it is possible to reduce the concern about the damage of the imaging element chip 13, to thin the imaging element chip 13 and to easily mount the imaging element module 10 into the electronic device.

When the thickness of the overcoat resin 30a covering the rear face of the imaging element chip 13 is increased, the overall thickness of the imaging element module 10 is also increased and cannot be introduced into a narrow mounting space. Also, not only the thickness of the overcoat resin 30a but also the flatness and parallelism thereof are also problematic. When the flatness and parallelism are large, the overall thickness of the imaging element module 10 is also increased.

Thus, in this illustrative embodiment, a parallelism between the rear face side becoming the conductive terminal surface of the rigid wiring substrate 11 and the rear face of the overcoat resin 30 (30a) (the face contacting the rear face side of the liquid crystal display device shown in Figs. 1A and 1B) is set to be 50 µm or smaller, preferably 30 µm or smaller. Thereby, it is possible to thin the imaging element module 10 and to improve the pressing ability of the anisotropic conductive adhesive that is used when attaching the flexible wiring substrate 22.

Also, in this illustrative embodiment, the flatness of the rear face side of the overcoat resin 30 (30a) is set to be 50 µm or smaller, preferably 30 µm or smaller. Thereby, it is possible to thin the imaging element module 10 and to improve the pressing ability of the anisotropic conductive adhesive.

The flexible wiring substrate 22 may be attached to the rear face side of the rigid wiring substrate 11, i.e., the side to which the imaging element chip 13 is attached. In this case, the connection part of the flexible wiring substrate 22 to the rigid wiring substrate 11 is preferably sealed together with the electric component 20 by the overcoat resin 30. Thereby, the mechanical strength and electrical connection strength of the connection part are improved.

The overcoat resin 30 (30a) is preferably a resin in which an epoxy-based material is used as a base material, and a thermal expansion coefficient thereof is preferably within a range of 2 to 20 ppm/K. When the thermal expansion coefficient of the overcoat resin 30 is excessively different from that of the imaging element chip 13, particularly, the imaging element chip 13 may be damaged by a thermal hysteresis in the manufacturing process of the imaging element module 10, and the reliability may be lowered when the imaging element module 10 is used for a long time.

When it is possible to select a material that can make the thermal expansion coefficient difference with the imaging element chip 13 be a predetermined value or smaller only by the overcoat resin 30 (30a), it is possible to make the thermal expansion coefficient difference small by mixing a glass filler in the overcoat resin 30 (30a). In this case, a particle diameter of the glass filler that is mixed is preferably 5 to 50 µm.

Although not shown in Fig. 2, at least two holes or recess portions are provided at the periphery of the rectangular opening 12 of the rigid wiring substrate 11. By using the holes or recess portions as a reference position, the cylindrically-shaped imaging lens unit having the imaging lens accommodated therein is attached to the rigid wiring substrate 11. The attachment position of the imaging lens unit may be also determined using an outward shape position of the rigid wiring substrate 11. Before attaching the imaging lens unit, the rear face side of the rigid wiring substrate 11 is sealed by the overcoat resin 30. At this time, however, the holes are blocked by mold pins so that the overcoat resin 30 does not leak through the holes for determining the reference position.

The formation positions of the positioning holes or recess portions of the imaging lens unit are preferably within a tolerance of ± 100 µm with respect to a copper foil pattern for reference position provided on an attachment face side of the imaging lens unit. When the imaging lens unit is assembled on the basis of the copper foil pattern position, it is not necessary to form the outward shape of the holes or recess portions for determining the reference position.

When attaching the imaging lens unit to the rigid wiring substrate 11, the copper foil position provided on the surface side of the rigid wiring substrate 11 is used as a reference. When flip-chip bonding the imaging element chip 13 to the rigid wiring substrate 11, the copper foil position provided on the rear face of the rigid wiring substrate 11 is used as a reference. At this time, a deviation tolerance of each copper foil position provided on the surface and rear face of the rigid wiring substrate 11 is set to be ±75 µm or smaller, so that the attachment position precision of the imaging lens unit to the imaging element chip 13 is within a permitted range.

The imaging lens unit attachment face side (surface side) of the rigid wiring substrate 11 is preferably provided with terminals to be connected to an actuator for positioning a focus of the imaging lens and the like or terminals for ground shield connection.

When manufacturing the imaging element module 10 as described above, a sheet-shaped rigid wiring substrate is formed with rectangular openings in a two-dimensional array shape, the optical filter glass 15 is attached to a surface side of each rectangular opening, the imaging element chip 13 is flip-chip bonded to a rear face side of each rectangular opening, the periphery of the imaging element chip 13 is sealed by a resin, the electric component 20 is surface-mounted on the rear face side of the rigid wiring substrate and the entire rear face side is covered by the overcoat resin 30. Also, the imaging lens unit is attached to an upper part of each filter glass and the rigid wiring substrate is diced and is thus individually pieced. Finally, the flexible wiring substrate 22 is connected to the individually pieced rigid wiring substrate, so that the imaging element module 10 is completed.

As described above, according to an imaging element module and a method for manufacturing the same of an illustrative embodiment, a first wiring substrate is formed with an opening, a front-side face of the opening of the first wiring substrate is covered by a transparent substrate, an imaging element chip is flip-chip bonded to a rear face side of the first wiring substrate with a light-receiving face being made to face the opening of the first wiring substrate, a gap formed between connection terminals of an electric connection part between a periphery of the light-receiving face of the imaging element chip and a peripheral edge part of the opening of the first wiring substrate is filled with a first resin, an entire rear face of the imaging element chip and the rear face side of the first wiring substrate are covered by a second resin, so that an exposed conductive part, which is exposed to the rear face side so that a surface of the rear face side is substantially parallel with a surface of the transparent substrate, is covered by the second resin and a second wiring substrate is electrically and mechanically connected to the first wiring substrate.

Also, according to the imaging element module and the method for manufacturing the same of the illustrative embodiment, the first wiring substrate is a rigid wiring substrate and the second wiring substrate is a flexible wiring substrate.

Also, according to the imaging element module and the method for manufacturing the same of the illustrative embodiment, a thickness of the second resin covering the entire rear face of the imaging element chip is within a range of 5 to 100 µm.

Also, according to the imaging element module and the method for manufacturing the same of the illustrative embodiment, an electric component that is mounted at the rear face side of the first wiring substrate by a surface mounting method and is sealed by the second resin is an electric component that is thinner than the thickness of the imaging element chip.

Also, according to the imaging element module and the method for manufacturing the same of the illustrative embodiment, an electric component that is thicker than the thickness of the imaging element chip is mounted at a surface side of the first wiring substrate by the surface mounting method.

Also, according to the imaging element module and the method for manufacturing the same of the illustrative embodiment, the second wiring substrate is connected to the first wiring substrate by an anisotropic conductive adhesive.

Also, according to the imaging element module and the method for manufacturing the same of the illustrative embodiment, the second resin containing therein a glass filler is used.

Also, according to the imaging element module and the method for manufacturing the same of the illustrative embodiment, a parallelism between a rear face of the second resin, which covers the entire rear face of the imaging element chip, and a rear face of the first wiring substrate is 50 µm or smaller.

Also, according to the imaging element module and the method for manufacturing the same of the illustrative embodiment, a flatness of a rear face side of the second resin is 50 µm or smaller.

Also, according to the imaging element module and the method for manufacturing the same of the illustrative embodiment, a protective member that prevents the second resin from protruding towards the light-receiving face side of the imaging element chip upon filling of the second resin is used instead of the first resin.

According to the above illustrative embodiment, since the entire rear face of the imaging element chip is covered with the resin film and the rear face is made to be substantially parallel with the surface of the transparent substrate, it is possible to reduce a concern about the damage of the chip made of a fragile material even when the imaging element chip is made to be thin, to attach the imaging element chip in an electronic device with being closely contacted and to easily assemble the electronic device. Also, since the second resin is prevented from flowing towards the imaging element light-receiving face side by the first resin or another protective member before over-coating the rear face side of the first wiring substrate by the second resin, there is no concern that the light-receiving face is polluted due to the second resin.

### Industrial Applicability

Since the imaging element module of the invention is thin and has the configuration where the imaging element chip is not damaged well, it can be easily mounted in a narrow space. Thus, the imaging element module is useful as an imaging element module that is attached to a small-sized electronic device such as a portable phone.

Although the invention has been specifically described with reference to the illustrative embodiment, it is apparent to one skilled in the art that a variety of changes and modifications can be made without departing from the spirit and scope of the invention.

The application is based on a Japanese Patent Application No. 2011-179853 filed on August 19, 2011, the contents thereof being incorporated herein by reference.

### Description of Reference Numerals and Symbols

10: Imaging Element Module (Camera Module) Main Body
11: Rigid Wiring Substrate
12: Rectangular Opening
13: Imaging Element Chip (Semiconductor Chip)
14: Gold Bump By Flip-Chip Bonding
15: Optical Filter Glass
16: Internal Space
18: Gap Between Bumps
20: Electric Component
22: Flexible Wiring Substrate
23: Anisotropic Conductive Adhesive

## Claims

1. An imaging element module comprising:
a first wiring substrate that is formed with an opening;
a transparent substrate that covers and blocks a front-side face of the opening of the first wiring substrate;
an imaging element chip that is flip-chip bonded to a rear face side of the first wiring substrate with a light-receiving face being made to face the opening of the first wiring substrate;
a first resin that fills a gap formed between terminals electrically connecting a periphery of the light-receiving face of the imaging element chip and a peripheral edge part of the opening of the first wiring substrate;
a second resin that covers an entire rear face of the imaging element chip and the rear face side of the first wiring substrate to cover an exposed conductive part, which is exposed to the rear face side, a surface of the rear face side being substantially parallel with a surface of the transparent substrate, and
a second wiring substrate that is electrically and mechanically connected to the first wiring substrate.

2. The imaging element module according to claim 1, wherein the first wiring substrate is a rigid wiring substrate and the second wiring substrate is a flexible wiring substrate.

3. The imaging element module according to claim 1 or 2, wherein a thickness of the second resin covering the entire rear face of the imaging element chip is within a range of 5 to 100 µm.

4. The imaging element module according to one of claims 1 to 3, wherein a thickness of an electric component that is mounted at the rear face side of the first wiring substrate by a surface mounting method and is sealed by the second resin is thinner than a thickness of the imaging element chip.

5. The imaging element module according to one of claims 1 to 4, wherein a thickness of an electric component that is mounted at a surface side of the first wiring substrate by the surface mounting method is thicker than a thickness of the imaging element chip.

6. The imaging element module according to one of claims 1 to 5, wherein the second wiring substrate is connected to the first wiring substrate by an anisotropic conductive adhesive.

7. The imaging element module according to one of claims 1 to 6, wherein the second resin contains therein a glass filler.

8. The imaging element module according to one of claims 1 to 7, wherein a parallelism between a rear face of the second resin, which covers the entire rear face of the imaging element chip, and a rear face of the first wiring substrate is 50 µm or smaller.

9. The imaging element module according to one of claims 1 to 8, wherein a flatness of a rear face side of the second resin is 50 µm or smaller.

10. The imaging element module according to one of claims 1 to 9, wherein a protective member that prevents the second resin from protruding towards the light-receiving face side of the imaging element chip upon filling of the second resin is provided instead of the first resin.

11. A method of manufacturing an imaging element module comprising:
forming an opening in a first wiring substrate;
covering a front-side face of the opening of the first wiring substrate by a transparent substrate;
flip-chip bonding an imaging element chip to a rear face side of the first wiring substrate with a light-receiving face being made to face the opening of the first wiring substrate;
filling a gap, which is formed between connection terminals of an electric connection part between a periphery of the light-receiving face of the imaging element chip and a peripheral edge part of the opening of the first wiring substrate, with a first resin;
covering an entire rear face of the imaging element chip and the rear face side of the first wiring substrate by a second resin, thereby covering an exposed conductive part, which is exposed to the rear face side by the second resin so that a surface of the rear face side is substantially parallel with a surface of the transparent substrate; and
electrically and mechanically connecting a second wiring substrate to the first wiring substrate.

12. The method of manufacturing an imaging element module, according to claim 11, wherein the first wiring substrate is a rigid wiring substrate and the second wiring substrate is a flexible wiring substrate.

13. The method of manufacturing an imaging element module, according to claim 11 or 12, wherein a thickness of the second resin covering the entire rear face of the imaging element chip is within a range of 5 to 100 µm.

14. The method of manufacturing an imaging element module, according to one of claims 11 to 13, wherein an electric component that is mounted at the rear face side of the first wiring substrate by a surface mounting method and is sealed by the second resin is an electric component that is thinner than a thickness of the imaging element chip.

15. The method of manufacturing an imaging element module, according to one of claims 11 to 14, wherein an electric component that is thicker than a thickness of the imaging element chip is mounted at a surface side of the first wiring substrate by the surface mounting method.

16. The method of manufacturing an imaging element module, according to one of claims 11 to 15, wherein the second wiring substrate is connected to the first wiring substrate by an anisotropic conductive adhesive.

17. The method of manufacturing an imaging element module, according to one of claims 11 to 16, wherein the second resin containing therein a glass filler is used.

18. The method of manufacturing an imaging element module, according to one of claims 11 to 17, wherein a parallelism between a rear face of the second resin, which covers the entire rear face of the imaging element chip, and a rear face of the first wiring substrate is 50 µm or smaller.

19. The method of manufacturing an imaging element module, according to one of claims 11 to 18, wherein a flatness of a rear face side of the second resin is 50 µm or smaller.

20. The method of manufacturing an imaging element module, according to one of claims 11 to 19, wherein a protective member that prevents the second resin from protruding towards the light-receiving face side of the imaging element chip upon filling of the second resin is provided instead of the first resin.
